# EUROPEAN PATENT APPLICATION

(11) **EP 0 543 282 A1**
(43) Date of publication of application: **26.05.1993**
(21) Application number: 92119388.4
(22) Date of filing: 12.11.1992
(51) Int. Cl.: H01L 27/06, H01L 27/02

(54) **Semiconductor device**

(30) Priority: 19.11.1991 JP 302997/91
(71) Applicant: MATSUSHITA ELECTRIC INDUSTRIAL CO., LTD., Kadoma-shi, Osaka-fu, 571 (JP)
(72) Inventor: Yagita, Hideki, Hirakata-shi, Osaka 573 (JP); Horie, Masakiyo, Yokohama-shi, Kanagawa 240 (JP)
(74) Representative: Grünecker, Kinkeldey, Stockmair & Schwanhäusser Anwaltssozietät

(57) **Abstract**

A back electrode almost entirely covers a back surface of a semi-insulating GaAs semiconductor substrate. A transistor region for a semiconductor integrated circuit, a wiring layer for supplying three types of source voltages, +5V, 0V, and -5V to the transistor region are provided on a front surface of the substrate. A maximum voltage of the source voltages, i.e., +5V is applied to the back electrode. Thereby, a linear distortion in a band of low frequencies is improved, while maintaining a high frequency property of the semiconductor integrated circuit on the semi-insulating GaAs semiconductor substrate.

## Description

### BACKGROUND OF THE INVENTION

This invention relates to a semiconductor device, and particularly relates to a semiconductor device in which a semiconductor integrated circuit composed of a large number of transistors is formed on a semi-insulating semiconductor substrate, for example, semi-insulating GaAs substrate.

In an integrated circuit formed on a semi-insulating GaAs semiconductor substrate (hereinafter referred to GaAs-IC), the mobility of electron is high and the parasitic capacitance thereof decreases owing to the substrate. Thus the GaAs-IC is superior in operation speed to an integrated circuit formed on a Si semiconductor substrate (herein after referred to Si-IC). Accordingly, it is common that the GaAs-IC is employed instead of the Si-IC in case with high frequency about 1GHz or higher. On the contrary, in a band of frequencies about 100MHz or lower, the GaAs-IC may be inferior in 1/f noise figure to the Si-IC. Further, it is known that in a band of further lower frequencies such as direct current to 100Hz, the GaAs-IC has problems in a linear distortion, hysteresis of device parameters, commonly called a substrate bias effect and the like. As a result, the conventional GaAs-IC is used in a limited field practically in a band of high frequencies about 100MHz or higher.

A high-speed semiconductor device has been promoted, and especially desired is a high-speed semiconductor device which has such a good property as the Si-IC in the band of low frequencies. But now, such a limitation that the GaAs-IC is used only in the band of high frequencies prevents the market development.

Philip Canfield et al., "The potential of p-well GaAs MESFET technology for precision integrated circuits," Digest of Technical Papers (IEEE International Solid-State Circuit Conference) pp.3065-3068, 1990 says that a linear distortion in a band of low frequencies in a GaAs-IC is caused due to a deep energy level of electron called EL2 which is required for making a GaAs substrate semi-insulating, and that the linear distortion in the band of low frequencies is improved by forming a p-type region, as a well, under a transistor formed on the GaAs substrate and by securing the p-type region to a source electrode potential of the transistor.

The conventional method that the p-type region is formed under the transistor, however, increases the parasitic capacitance of the transistor to the substrate, thus preventing speedup by forming the transistor on the semi-insulating semiconductor substrate. Moreover, it causes complicated manufacturing processes and a controllability to a threshold voltage Vth, which is one of important parameters of the transistor, is drastically lowered.

The present invention has its object of improving the linear distortion in the band of low frequencies, while maintaining the high frequency property of the GaAs-IC and expanding a usable field of the GaAs-IC.

### SUMMARY OF THE INVENTION

The inventors of the present invention have found the fact that the linear distortion in the band of low frequencies can be improved, while maintaining the high frequency property of a semiconductor integrated circuit on a semi-insulating GaAs semiconductor substrate by applying a direct-current bias voltage higher than or equal to a maximum voltage of source voltages applied for driving the semiconductor integrated circuit to the substrate. Also found is the fact that the linear distortion in the band of low frequencies is further improved by forming a low-resistance n-type region so as to surround the transistor on a front surface of the substrate and by applying also to the n-type region the direct-current bias voltage higher than or equal to a maximum voltage of the source voltages. The present invention has been made in view of both facts.

### BRIEF DESCRIPTION OF THE DRAWINGS

Fig.1 is a sectional view showing a construction of a semiconductor device according to a first embodiment of the present invention.

Fig.2 is a circuit diagram of a buffer amplifier which is formed on a front surface of a semi-insulating semiconductor substrate in the semiconductor device in Fig.1.

Fig.3 is an input/output wave form chart in case where 100Hz rectangular wave-form signal is inputted to the buffer amplifier in Fig.2, where substrate potential Vsub is 0V to +6V.

Fig.4 is a graph showing a relation between an input voltage and a steady output voltage in the same case as in Fig.3.

Fig.5 is a plan view showing a construction of a semiconductor device according to a second embodiment of the present invention.

Fig.6 is a sectional view, taken on line VI-VI of Fig.5.

### PREFERRED EMBODIMENT OF THE PRESENT INVENTION

Description is made below about two embodiments of the present invention.

### (FIRST EMBODIMENT)

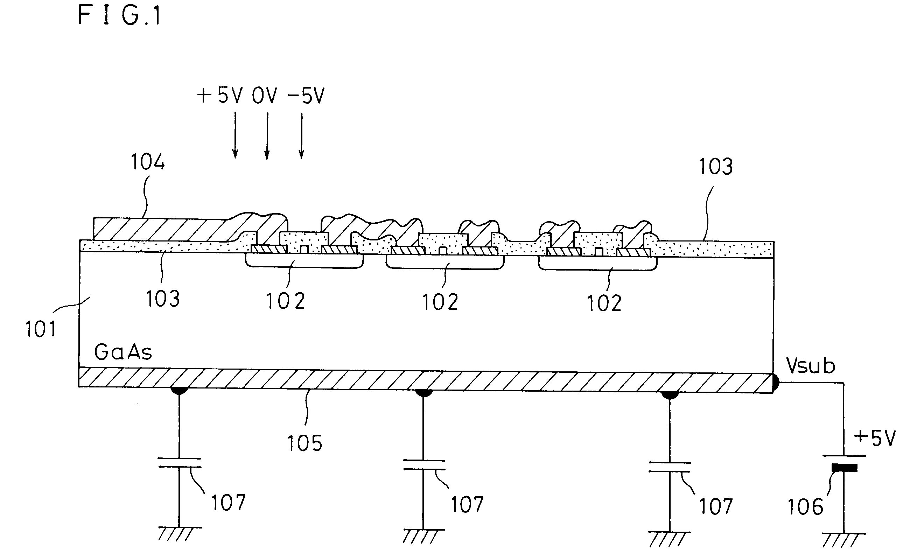

In Fig.1, a reference numeral 101 designates a semi-insulating GaAs semiconductor substrate. 102 is a transistor region composing a semiconductor integrated circuit. 103 is an inter-layer insulating film. 104 is a transistor wiring layer. 105 is a back electrode for giving a direct-current bias voltage to the substrate 101. 106 is a direct-current voltage source. 107 designates a bypass capacitor. The transistor region 102 receives three types of source voltages, i.e., +5V, 0V and -5V via the wiring layer 104. On the other hand, a maximum voltage of the three source voltages, i.e., +5V direct-current voltage is applied to a back surface of the substrate 101 as a substrate potential Vsub. As to a high frequency region, three condensers each having large static capacitance of, for example, 1000pF (more than 100pF static capacitance will suffice) are employed as the bypass capacitors 107 in order to firmly secure the substrate 101 to a ground potential. Wherein, the number of the condensers and the static capacitance thereof are not limited to them.

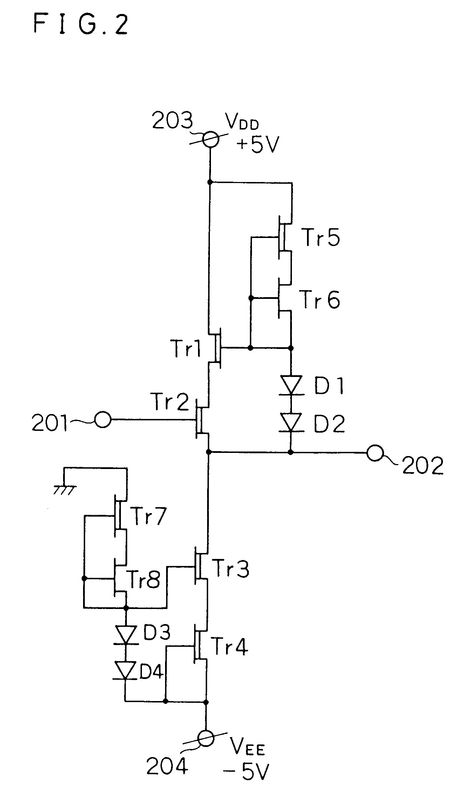

Fig.2 is a circuit diagram of a buffer amplifier which is formed in the transistor region 102 on a front surface of the semi-insulating GaAs semiconductor substrate 101, an output of which is applied to a sample & hold circuit in an A/D converter capable of operating in a band of high frequencies higher than 1GHz. In the figure, a reference numeral 201 designates an input terminal. 202 is an output terminal. 203 is a V_{DD} terminal. 204 is a V_{EE} terminal. V_{DD} and V_{EE} terminals 203, 204 receive +5V and -5V respectively. References Tr1 - Tr8 are depression type FETs and D1 - D4 are diodes. Wherein, the six FETs Tr1 - Tr5 and Tr7 are deeper in their threshold voltage Vth than the FETs Tr6 and Tr8. The circuit type is a source follower type impedance converting circuit, main element of which is the FET Tr2. The circuit includes conventional cascode-type current regulator provided on a drain side and a source side of the FET Tr2. The buffer amplifier is required to have a characteristic to transmit a signal without distortion in a wide band of frequencies from a direct current to 1GHz or higher to a sampler of a next stage composed of, for example, four diodes.

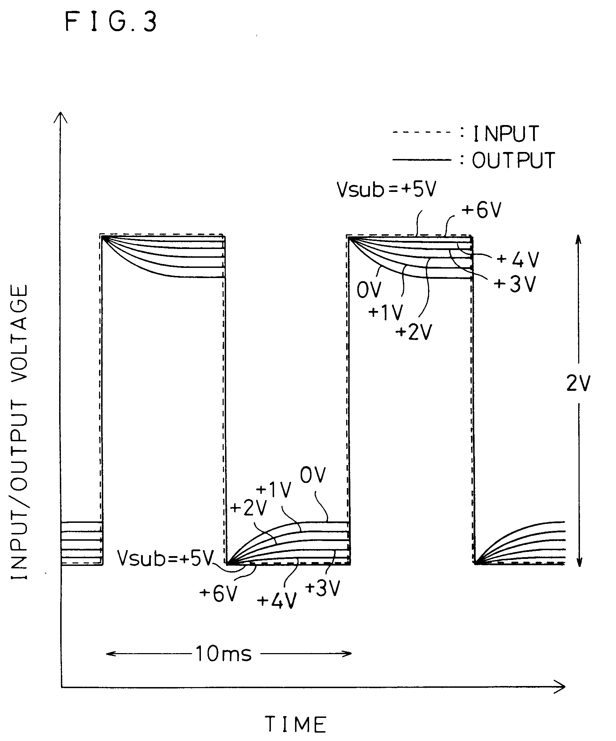

Fig.3 shows a voltage wave form of the output terminal 202 in case where 100Hz rectangular wave-form voltage signal is applied to the input terminal 201 of the buffer amplifier in Fig.2. In detail, it shows an experimental result of a linear distortion of an output wave form varying according to the substrate potential Vsub when an applied direct-current voltage of the back electrode 105, namely the substrate potential Vsub is set to 0V, +1V, +2V, +3V, +4V, +5V and +6V, respectively. It is cleared from Fig.3 that a transient of the output wave form, i.e., the linear distortion is restrained when a voltage higher than or equal to the maximum voltage, +5V (V_{DD}) of the source voltages for driving the buffer amplifier is applied to the back electrode 105 as the substrate potential Vsub. It belongs to a conventional technique to set the substrate potential Vsub of the semi-insulating GaAs semiconductor substrate 101 to 0V.

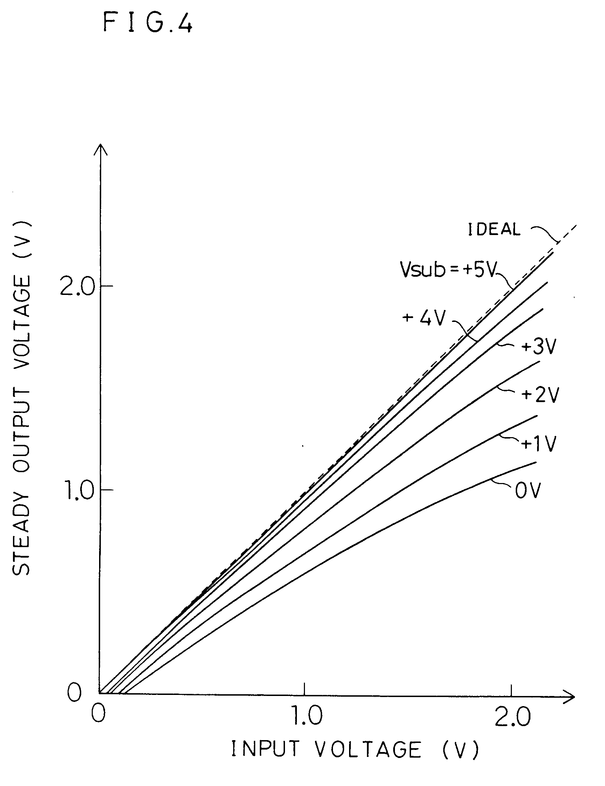

Fig.4 is a graph showing a relation between an input voltage and a steady output voltage regarding the substrate potential Vsub as a parameter, which is derived from the result in Fig.3. Fig.4 clearly indicates the distortion property of the buffer amplifier. A curve of the substrate potential Vsub of +5V almost conforms with a straight line representing an ideal property.

When a frequency of an input signal of the buffer amplifier is 500MHz, the same result is obtained as in the case of Figs.3 and 4. No deterioration in high frequency property is caused, different from a conventional one forming the p-type region under the transistor. In other words, according to this embodiment, the linear distortion in the band of low frequencies is improved, while maintaining the high frequency property, which leads to application of the device to a wide band of frequencies.

### (SECOND EMBODIMENT)

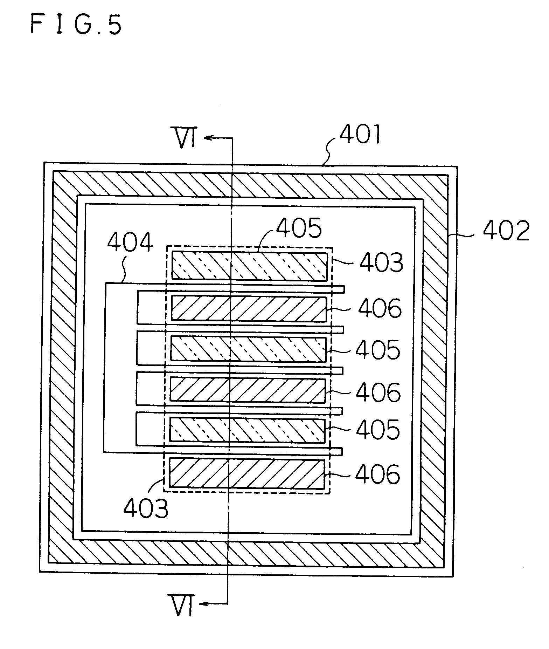

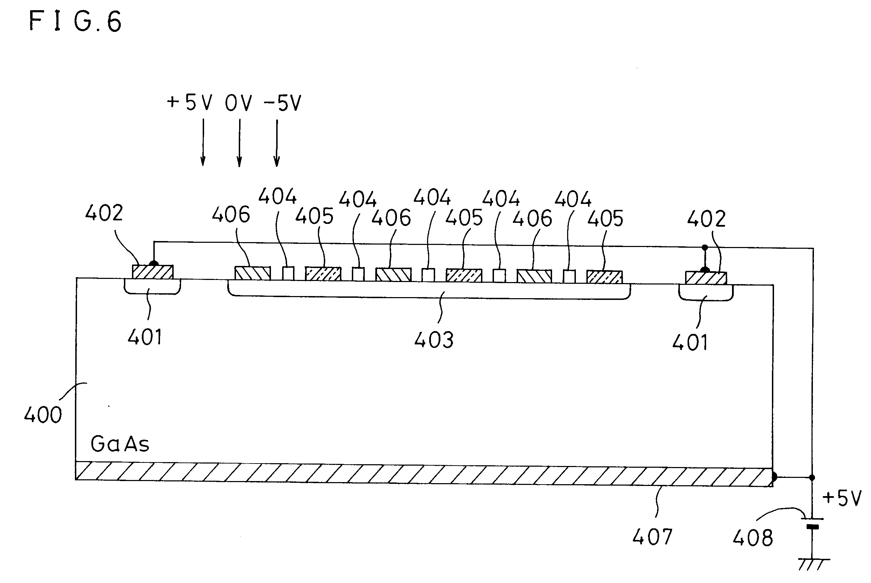

Figs.5 and 6 show another construction of semiconductor device. In this embodiment, too, the buffer amplifier having the circuit construction in Fig.2 is formed on a front surface of the semi-insulating GaAs semiconductor substrate as a semiconductor integrated circuit. However, only one transistor is drawn in Figs.5 and 6 respectively for avoiding its complication.

In Figs.5 and 6, reference numeral 400 designates a semi-insulating GaAs semiconductor substrate. 401 is a low-resistance n-type region surrounding the transistor. 402 is a front electrode for applying a direct-current bias voltage to the low-resistance n-type region 401. 403 is an active area of the transistor. 404 is a gate multifinger electrode of the transistor. 405 is a source electrode of the transistor. 406 is a drain electrode of the transistor. 407 is a back electrode for applying the direct-current bias voltage to the substrate 400. 408 is a direct-current voltage source. Three types of source voltages, +5V, 0V and -5V are given to the transistor, and a maximum voltage of the three types of source voltages, i.e., +5V direct-current voltage is applied to both of the front electrode 402 for the low-resistance n-type region 401 and the back electrode 407 for the substrate 400. Wherein, the low-resistance n-type region 401 is arranged so as not to contact with any n-type regions of the transistor. Similar to the case in Fig.1, the substrate 400 is secured to the ground potential as to the high frequency.

According to this embodiment, not only the semi-insulating GaAs semiconductor substrate 400 but also the low-resistance n-type region 401 surrounding the transistor are biased to +5V. Thereby, an electrical interference from outside of the low-resistance n-type region 401 to the active area 403 of the transistor is prevented. It is confirmed by an experiment that the linear distortion in the band of low frequencies is further improved, while maintaining the high frequency property, compared with the first embodiment.

## Claims

1. A semiconductor device comprising:
a semi-insulating semiconductor substrate having front and back surfaces;
a semiconductor integrated circuit having transistors on the front surface of said semi-insulating semiconductor substrate; and
a back electrode almost entirely covering the back surface of said semi-insulating semiconductor substrate,
wherein one or more direct-current source voltages are applied to said semiconductor integrated circuit, and a direct-current bias voltage higher than or equal to a maximum voltage of the direct-current source voltages is applied to said back electrode.

2. The semiconductor device according to Claim 1, wherein said transistors include n-type regions, said semiconductor device further comprising:
a low-resistance n-type region surrounding said transistors and arranged so as not to contact with said n-type regions on the front surface of said semi-insulating semiconductor substrate; and
a front electrode for biasing said low-resistance n-type region,
wherein a direct-current bias voltage higher than or equal to a maximum voltage of the direct-current source voltages is applied to said front electrode.
